(19) Europäisches Patentamt
European Patent Office
Office européen des brevets

(11) **EP 3 549 178 B1**

(12) **FASCICULE DE BREVET EUROPEEN**

(45) Date de publication et mention de la délivrance du brevet:
**22.06.2022 Bulletin 2022/25**

(21) Numéro de dépôt: **17816957.9**

(22) Date de dépôt: **30.11.2017**

(51) Classification Internationale des Brevets (IPC):
**H01L 33/00** (2010.01)    **H01L 33/20** (2010.01)

(52) Classification Coopérative des Brevets (CPC):
**H01L 33/20;** H01L 2933/0083

(86) Numéro de dépôt international:
**PCT/FR2017/053327**

(87) Numéro de publication internationale:
**WO 2018/100316 (07.06.2018 Gazette 2018/23)**

(54) **DISPOSITIF OPTOÉLECTRONIQUE À DIODE ÉLECTROLUMINESCENTE À EXTRACTION AUGMENTÉE**

OPTOELEKTRONISCHE VORRICHTUNG MIT LEUCHTDIODE MIT EXTRAKTIONSVERBESSERUNG

OPTOELECTRONIC DEVICE WITH LIGHT-EMITTING DIODE WITH EXTRACTION ENHANCEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2016 FR 1661879**

(43) Date de publication de la demande:
**09.10.2019 Bulletin 2019/41**

(73) Titulaire: **Commissariat à l'Energie Atomique et aux Energies Alternatives**
**75015 Paris (FR)**

(72) Inventeurs:
• **TEMPLIER, François**
**38054 Grenoble Cedex 9 (FR)**
• **BOUTAMI, Salim**
**38100 Grenoble (FR)**

(74) Mandataire: **Cabinet Beaumont**
**4, Place Robert Schuman**
**B.P. 1529**
**38025 Grenoble Cedex 1 (FR)**

(56) Documents cités:
| | |
|---|---|
| **EP-A1- 1 995 794** | **EP-A1- 2 752 895** |
| **EP-A2- 1 624 499** | **EP-A2- 2 355 182** |
| **US-A1- 2004 206 969** | **US-A1- 2012 012 874** |
| **US-A1- 2015 117 015** | |

**Description**

Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes.

Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière.

De façon générale, le dispositif optoélectronique comprend au moins une diode électroluminescente formée par un empilement de couches semiconductrices. La zone active est la zone de la diode électroluminescente depuis laquelle est émise la majorité du rayonnement fourni par la diode électroluminescente. La zone active peut comporter des moyens de confinement. A titre d'exemple, la zone active peut comprendre un puits quantique unique ou des puits quantiques multiples.

L'efficacité d'extraction d'un dispositif optoélectronique est généralement définie par le rapport entre le nombre de photons qui s'échappent du dispositif optoélectronique et le nombre de photons émis par la zone active du dispositif. Il est souhaitable que l'efficacité d'extraction d'un dispositif optoélectronique soit la plus élevée possible. Toutefois, une partie du rayonnement peut rester piégée dans le dispositif optoélectronique.

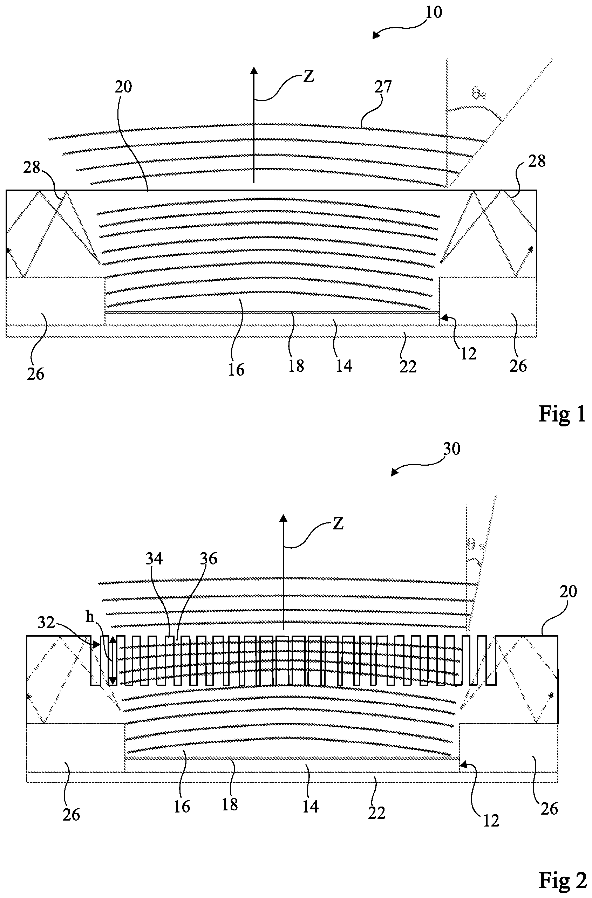

La figure 1 est une vue en coupe, partielle et schématique, d'un mode de réalisation d'un dispositif optoélectronique 10, ne faisant pas partie de l'invention, comprenant une diode électroluminescente. A titre d'exemple, le dispositif optoélectronique 10 peut avoir une structure à symétrie de révolution. Le dispositif optoélectronique 10 comprend un empilement 12 de couches semiconductrices, par exemple comprenant majoritairement un alliage d'un élément du groupe III et d'un élément du groupe V, par exemple le GaN. L'empilement peut comprendre une couche semiconductrice 14 dopée d'un premier type de conductivité, par exemple dopée de type P, une couche semiconductrice 16 dopée d'un deuxième type de conductivité opposé au premier type, par exemple dopée de type N, et une zone active 18 prise en sandwich entre les couches semiconductrices 14 et 16. La couche semiconductrice 16 comprend une face 20, appelée face d'émission ou face avant, par laquelle s'échappe le rayonnement électromagnétique émis par la zone active 18. On appelle Z la direction perpendiculaire à la face 20.

Le dispositif optoélectronique 10 comprend, en outre, un plot 22 conducteur électriquement au contact de la couche semiconductrice 14. Le dispositif électronique 10 comprend, en outre, un plot conducteur électriquement, non représenté, relié à la couche semiconductrice 16. Le dispositif optoélectronique 10 comprend, en outre, une portion isolante électriquement 26 délimitant latéralement la couche semiconductrice 14 et la zone active 18. Les plots conducteurs permettent d'alimenter la zone active 18 pour l'émission d'un rayonnement électromagnétique.

Une partie du rayonnement électromagnétique s'échappe directement par la face d'émission 20 sans que les ondes électromagnétiques ne se réfléchissent sur les parois du dispositif optoélectronique 10. Ce mode de propagation du rayonnement électromagnétique est appelé mode radiatif direct et est représenté de façon schématique en figure 1 par des fronts d'onde 27. La directivité du dispositif optoélectronique 10 correspond à la proportion du rayonnement qui s'échappe par la face d'émission 20 selon la même direction. Plus cette proportion est importante, plus le dispositif optoélectronique est directif. Les rayons lumineux du mode radiatif direct sont sensiblement orthogonaux à la face d'émission 20 de sorte que le dispositif optoélectronique 10 est directif lorsque seul le mode radiatif direct est présent. Toutefois, le faisceau qui s'échappe du dispositif optoélectronique 10 dû au mode radiatif direct est généralement divergent. En figure 1, on a représenté le demi-angle de divergence $\theta_e$ du faisceau émis par le dispositif optoélectronique 10.

Une partie du rayonnement électromagnétique se réfléchit sur les parois du dispositif optoélectronique 10 selon différents chemins. Ces modes de propagation sont appelés modes guidés. Des modes guidés sont représentés de façon schématique en figure 1 par des rayons 28 qui se réfléchissent sur des parois du dispositif optoélectronique 10. Au moins une partie du rayonnement électromagnétique qui se propage selon des modes guidés peut rester piégée dans le dispositif optoélectronique 10.

Il est connu de former un réseau périodique de diffraction sur la face avant 20 pour augmenter l'efficacité d'extraction du dispositif optoélectronique 10. Un réseau périodique de diffraction comprend, par exemple, des rainures rectilignes ou circulaires formées dans la face avant 20. Un tel réseau présente au moins une symétrie, par exemple une symétrie axiale, une symétrie par rapport à un plan ou une symétrie de révolution autour d'un axe, et comprend, dans un plan contenant l'axe de symétrie ou dans le plan de symétrie, un motif (portions en creux et/ou portions en relief) répété de façon périodique. Le réseau de diffraction permet d'extraire au moins en partie le rayonnement se propageant dans la couche semiconductrice 16 selon des modes guidés. US 2012/0012874 A1, EP 2752895 A1,

EP 2355182 A2, EP 1995794 A1, US 2015/0117015 A1 et US 2004/0206969 A1 divulguent un dispositif optoélectronique à diode électroluminescente comprenant un réseau de diffraction.

Toutefois, un inconvénient du réseau périodique de diffraction est qu'il dégrade la directivité du dispositif optoélectronique 10. En effet, la direction d'émission du rayonnement par le réseau périodique de diffraction dépend du mode guidé. L'épaisseur de la couche semiconductrice 16 peut être supérieure à quelques micromètres de sorte que le dispositif optoélectronique 10 présente généralement de nombreux modes guidés qui sont extraits par le réseau périodique de diffraction selon des directions d'émission différentes.

Résumé

Un objet d'un mode de réalisation est de pallier tout ou partie des inconvénients des dispositifs optoélectroniques décrits précédemment, notamment des dispositifs optoélectroniques comprenant des réseaux périodiques de diffraction.

Un autre objet d'un mode de réalisation est d'augmenter l'efficacité d'extraction du dispositif optoélectronique.

Un autre objet d'un mode de réalisation est d'augmenter la directivité du rayonnement électromagnétique émis par le dispositif optoélectronique.

Un autre objet d'un mode de réalisation est de réduire la divergence du faisceau émis par le dispositif optoélectronique.

Ainsi, l'invention prévoit un dispositif optoélectronique selon la revendication 1.

Selon l'invention, les trous sont agencés en rangées et en colonnes.

Selon un mode de réalisation, les trous sont à section droite circulaire, ellipsoïdale ou polygonale.

Selon un mode de réalisation, l'épaisseur de la première couche semiconductrice est comprise entre 1 $\mu$m et 10 $\mu$m.

Selon un mode de réalisation, la profondeur des trous est comprise entre 30 nm et 3 $\mu$m.

Selon un mode de réalisation, les première et deuxième couches semiconductrices sont au moins en partie formées à partir d'au moins un matériau semiconducteur choisi parmi le groupe comprenant les composés III-V, les composés II-VI ou les semiconducteurs ou composés du groupe IV.

Selon un mode de réalisation, la distance entre les points milieu de deux trous adjacents selon une direction radiale du réseau de diffraction est inférieure à la moitié de la longueur d'onde du rayonnement électromagnétique.

L'invention prévoit également un procédé de fabrication d'un dispositif optoélectronique selon la revendication 7.

Selon un mode de réalisation, le procédé comprend une étape de détermination de la profondeur h des trous et de détermination, pour chaque trou, d'un facteur de remplissage f égal au rapport de la largeur, mesurée radialement depuis un centre du réseau de diffraction, dudit trou et la distance, mesurée radialement, entre les points milieu de deux trous adjacents selon une direction radiale du réseau de diffraction, le facteur de remplissage f et la hauteur h étant déterminés selon les relations suivantes :

$$\tilde{n}(r)=\tilde{n}(0)\text{-}n_i\frac{\left|\sqrt{(F\text{-}h)^2+r^2}\text{-}(F\text{-}h)\right|}{h}$$

$$\tilde{n}(r)=\sqrt{f(r)n_e{}^2+(1\text{-}f(r))n_i{}^2}$$

$$F=\frac{R\cos((n_e/n_i)\sin\theta_e)}{(n_e/n_i)\sin\theta_e}$$

où r est la distance entre le point milieu du trou et le centre, R est le rayon, mesuré depuis le centre, du cercle circonscrit au réseau de diffraction, $n_i$ est l'indice de réfraction de la première couche semiconductrice à la longueur d'onde du rayonnement électromagnétique, $n_e$ est l'indice de réfraction du milieu au contact de la première couche semiconductrice à la longueur d'onde du rayonnement électromagnétique, $\theta_e$ est le demi-angle de divergence du faisceau émis par le dispositif optoélectronique en l'absence du réseau de diffraction, et $\tilde{n}(r)$ est l'indice de réfraction moyen à la distance r qui permet, en l'absence du réseau de diffraction, d'obtenir la même déviation d'un rayon extrait hors de la première couche semiconductrice que celle obtenue en présence du réseau de diffraction.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, décrite précédemment, est une vue en coupe, partielle et schématique, d'un exemple d'un dispositif optoélectronique à diode électroluminescente ne faisant pas partie de l'invention;

la figure 2 est une vue en coupe, partielle et schématique, d'un mode de réalisation d'un dispositif optoélectronique à diode électroluminescente selon l'invention;

les figures 3 et 4 sont des vues de dessus, partielles et schématiques, de modes de réalisation, respectivement selon l'invention et ne faisant pas partie de l'invention, d'un réseau de diffraction du dispositif optoélectronique de la figure 2 ;

les figures 5A à 5I sont des vues en coupe, partielles et schématiques, des structures obtenues à des étapes successives d'un mode de réalisation d'un procédé de fabrication d'un dispositif optoélectronique du type de celui représenté sur la figure 2 ; et

les figures 6A à 6J sont des vues en coupe, partielles et schématiques, des structures obtenues à des étapes successives d'un autre mode de réalisation d'un procédé de fabrication d'un dispositif optoélectronique du type de celui représenté sur la figure 2.

## Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, la structure de la zone active d'une diode électroluminescente est bien connue de l'homme du métier et n'est pas décrite en détail par la suite. Sauf précision contraire, les expressions "approximativement", "sensiblement", et "de l'ordre de" signifient à 10 % près, de préférence à 5 % près.

La figure 2 est une vue en coupe, partielle et schématique, d'un mode de réalisation d'un dispositif optoélectronique 30 à diode électroluminescente selon l'invention.

Le dispositif optoélectronique 30 comprend l'ensemble des éléments du dispositif optoélectronique 10 représentée en figure 1 à la différence qu'il comprend, en outre, un réseau de diffraction 32 formé dans la couche semiconductrice 16 depuis la face avant 20. Le réseau de diffraction 32 comprend des ouvertures non traversantes 36, ou trous borgnes, qui s'étendent dans la couche semiconductrice 16 depuis la face 20 sur une partie de l'épaisseur de la couche semiconductrice 16. Les trous 36 délimitent des portions 34 de la couche semiconductrice 16 en relief par rapport au fonds des trous 36.

Dans le présent mode de réalisation, la face avant 20 est au contact de l'air. A titre de variante, le dispositif optoélectronique 30 peut comprendre au moins une couche supplémentaire qui recouvre la couche semiconductrice 16 et qui est sensiblement transparente à la longueur d'onde du rayonnement électromagnétique émis par la zone active 18. Dans ce cas, la couche supplémentaire pénètre notamment dans les trous 36.

Selon l'invention, le réseau de diffraction 32 n'a pas de structure périodique. Cela signifie qu'il n'y a pas de plan de coupe dans lequel le réseau de diffraction 32 présente un motif qui est répété de façon périodique. Selon l'invention, la largeur des trous 36, mesurée dans un plan perpendiculaire à la direction Z, présente un gradient. Selon l'invention, la dimension des trous 36 augmente depuis une région centrale du réseau de diffraction 32 vers la périphérie du réseau de diffraction 32. Selon l'invention, l'augmentation de la dimension des trous 36 depuis une région centrale du réseau de diffraction 32 vers la périphérie du réseau de diffraction 32 est continue. Selon un mode de réalisation, la dimension des portions en relief 34 diminue depuis une région centrale du réseau de diffraction 32 vers la périphérie du réseau de diffraction 32. La largeur des portions en relief 34 et/ou la largeur des trous 36, mesurée dans un plan perpendiculaire à la direction Z, est à une échelle nanométrique, c'est-à-dire comprise entre 20 nm et 200 nm. De préférence, les trous 36 ont tous sensiblement la même profondeur h.

La structure apériodique du réseau de diffraction 32 permet, de façon avantageuse, de réduire la divergence du faisceau émis par le dispositif optoélectronique 30. En effet, pour le rayonnement électromagnétique émis par la zone active 18 et se propageant selon le mode radiatif direct, tout se passe sensiblement comme si le réseau de diffraction 32 était remplacé par une couche superficielle présente en surface de la couche semiconductrice 16 et dont l'indice de réfraction à la longueur d'onde du rayonnement électromagnétique émis par la zone active 18 présente un gradient dans un plan perpendiculaire à la direction Z, l'indice de réfraction local diminuant du centre du réseau de diffraction 32 jusqu'à la périphérie du réseau de diffraction 32. Le gradient de l'indice de réfraction local de la couche superficielle vu par le rayonnement électromagnétique entraîne une meilleure collimation du faisceau émis par le dispositif optoélectronique 30, c'est-à-dire une diminution du demi-angle de divergence $\theta_e$ du faisceau émis par le dispositif optoélectronique 30.

En outre, la structuration du réseau de diffraction 32 à une échelle nanométrique crée un abaissement de l'indice de réfraction local au niveau de la face avant 20 par rapport à l'indice du reste de la couche semiconductrice 16. Ceci entraîne une réduction de la réflexion à l'interface entre la couche semiconductrice 16 et la couche d'air adjacente et donc une réduction de l'excitation des modes guidés. L'efficacité d'extraction du dispositif optoélectronique 30 est ainsi augmentée. En outre, comme la proportion du rayonnement électromagnétique se propageant dans la couche semiconductrice 16 selon des modes guidés diminue, la proportion des modes guidés qui sont extraits par le réseau de diffraction 32 diminue. La directivité du dispositif optoélectronique 30 est donc augmentée.

Selon un mode de réalisation, les dimensions latérales de la zone active 18 sont inférieures aux dimensions latérales du réseau de diffraction 32. Ceci permet une extraction efficace de la lumière émise par la zone active 18.

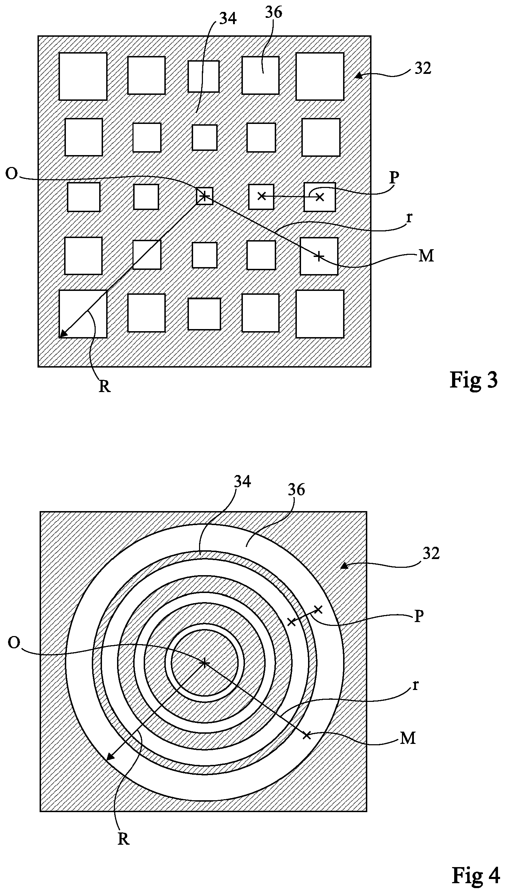

La figure 3 est une vue de dessus, partielle et schématique, d'un mode de réalisation du réseau de diffraction 32, selon l'invention, dans lequel les ouvertures 36 correspondent à des trous de section droite circulaire, ellipsoïdale ou polygonale, par exemple carrée comme cela est représenté en figure 3. Selon l'invention, les trous 36 sont agencés en rangées et en colonnes. Bien que le réseau de diffraction 32 présente une certaine régularité, il est néanmoins apériodique dans la mesure où les dimensions des trous 36 ne sont pas constantes. La section droite des trous augmente en s'éloignant du centre O du réseau de diffraction 32.

La figure 4 est une vue de dessus, partielle et schématique, d'un mode de réalisation du réseau de diffraction 32, ne faisant pas partie de l'invention, dans lequel les trous 36 correspondent à des rainures circulaires et concentriques. Dans le présent mode de réalisation, le réseau de diffraction 32 est à symétrie de révolution. Selon un mode de réalisation, la largeur des rainures 36 augmente en s'éloignant du centre O du réseau de diffraction 32.

On repère un point M du réseau de diffraction 32 par le rayon r, mesuré dans un plan perpendiculaire à la direction Z, entre les points M et le centre O du réseau de diffraction 32.

Le réseau de diffraction 32 peut être caractérisé par différentes relations qui vont être détaillées par la suite. Dans ce but, on utilise les notations suivantes :

h est la profondeur, également appelé hauteur, des trous 36 ;

$n_i$ est l'indice de réfraction du milieu composant la couche semiconductrice 16 à la longueur d'onde du rayonnement électromagnétique fourni par la zone active 18 ;

$n_e$ est l'indice de réfraction du milieu adjacent à la couche semiconductrice 16 à la longueur d'onde du rayonnement électromagnétique fourni par la zone active 18, par exemple l'indice de l'air dans le présent mode de réalisation ;

P est la pseudopériode du réseau de diffraction 32, et correspond à la distance entre des "points milieu" de trous 36 adjacents mesurée dans un plan perpendiculaire à la direction Z selon une direction radiale. Dans le mode de réalisation représenté en figure 3, la pseudopériode P correspond à la distance, mesurée dans un plan perpendiculaire à la direction Z, entre les centres de trous 36 adjacents et alignés avec le centre O. Dans le mode de réalisation représenté en figure 4, la pseudopériode P correspond à la distance, mesurée dans un plan perpendiculaire à la direction Z selon une direction radiale, entre les squelettes de deux rainures 36 adjacentes, le squelette d'une rainure étant la courbe correspondant au lieu géométrique des points situés à égale distance, mesurée radialement, des bords de la rainure ;

R est le rayon maximal du cercle dans lequel est inscrit, en vue de dessus, le réseau de diffraction 32 ;

f(r) est le facteur de remplissage local du réseau de diffraction 32 défini au point M comme le rapport de la largeur, mesurée radialement, du trou 36 le plus proche du point M sur la pseudopériode P ; et

$\tilde{n}(r)$ est l'indice de réfraction moyen au point M à la longueur d'onde du rayonnement électromagnétique émis par la zone active 18, c'est-à-dire l'indice de réfraction que devrait avoir la couche semiconductrice 16 sur l'épaisseur h pour obtenir, en l'absence du réseau de diffraction 32, la même déviation d'un rayon extrait hors de la couche semiconductrice 16 que celle obtenue en présence du réseau de diffraction.

La pseudopériode P traduit le fait que le réseau de diffraction 32 présente une certaine régularité. Toutefois, le réseau de diffraction 32 est un réseau apériodique dans la mesure où il ne comprend pas de motif reproduit de façon périodique.

Les expressions de la pseudopériode P, du facteur de remplissage local f(r) et de l'indice de réfraction moyen $\tilde{n}(r)$ sont données par la suite par des fonctions continues qui dépendent notamment du rayon r. Toutefois, ces fonctions sont à appliquer de manière discrète en chaque trou 36 et/ou chaque portion en relief 34 du réseau de diffraction.

Pour pouvoir considérer que le réseau de diffraction 32 se comporte comme une couche superficielle avec l'indice de réfraction local $\tilde{n}(r)$, la pseudopériode P doit vérifier la relation (1) suivante :

$$P < \frac{\lambda}{2} \qquad\qquad\qquad (1)$$

où $\lambda$ est la longueur d'onde du rayonnement émis par la zone active 18.

De plus, on a les relations (2), (3) et (4) suivantes :

$$\tilde{n}(r)=\tilde{n}(0)-n_i\frac{\left|\sqrt{(F\text{-}h)^2+r^2}\text{-}(F\text{-}h)\right|}{h} \tag{2}$$

$$\tilde{n}(r)=\sqrt{f(r)n_e{}^2+(1\text{-}f(r))n_i{}^2} \tag{3}$$

$$F=\frac{R\cos((n_e/n_i)\sin\theta_e)}{(n_e/n_i)\sin\theta_e} \tag{4}$$

Dans la relation (4), le demi-angle de divergence $\theta_e$ est celui obtenu en l'absence du réseau de diffraction 32.

La distance F peut être vu comme la distance entre la face avant 20 et une source ponctuelle virtuelle qui donnerait le même front d'onde sur la face avant 20 que la zone active 18. Comme la zone active 18 fournit un rayonnement électromagnétique moins divergent qu'une source ponctuelle, la distance F est donc toujours supérieure à la distance entre la zone active 18 et la face avant 20.

Le facteur de remplissage f est compris entre un facteur de remplissage minimum fmin et un facteur de remplissage maximum fmax. Le facteur de remplissage minimum fmin est atteint au centre O du réseau de diffraction 32 et le facteur de remplissage maximum fmax est atteint à la périphérie du réseau de diffraction 32. Les facteurs de remplissage fmin et fmax sont notamment imposés par les procédés mis en oeuvre pour la formation des portions en relief 34 et des trous 36.

Les facteurs de remplissages fmin et fmax permettent de déterminer la profondeur h. En effet, ils fixent les valeurs $\tilde{n}(0)$ et $\tilde{n}(R)$ par la relation (3). La profondeur h est alors donnée par la relation (2).

Selon un mode de réalisation, la profondeur h peut être comprise entre 30 nm et 3 $\mu$m. La dimension radiale maximale R du réseau de diffraction 32 est de préférence comprise entre 1 $\mu$m et 100 $\mu$m.

Selon un mode de réalisation, les couches semiconductrices de l'empilement 12 sont, au moins en partie, formées à partir d'au moins un matériau semiconducteur adapté à la formation d'une diode électroluminescente, notamment un matériau semiconducteur choisi parmi le groupe comprenant les composés III-V, les composés II-VI ou les semiconducteurs ou composés du groupe IV.

Les couches semiconductrices de l'empilement 12 peuvent être, au moins en partie, formées à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les couches semiconductrices de l'empilement 12 peuvent être, au moins en partie, formées à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les couches semiconductrices de l'empilement 12 peuvent être, au moins en partie, formées à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Les couches semiconductrices de l'empilement 12 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

La zone active 18 peut comporter des moyens de confinement. A titre d'exemple, la zone active 18 peut comprendre un puits quantique unique. Elle comprend alors un matériau semiconducteur différent du matériau semiconducteur formant les couches semiconductrices 14 et 16 et ayant une bande interdite inférieure à celle du matériau formant les couches semiconductrices 14 et 16. La zone active 18 peut comprendre des puits quantiques multiples. Elle comprend alors un empilement de couches semiconductrices formant une alternance de puits quantiques et de couches barrières.

L'épaisseur de la couche semiconductrice 14 peut être comprise entre 0,1 $\mu$m et 0,3 $\mu$m, par exemple environ

0,2 $\mu$m. L'épaisseur de la zone active 18 peut être comprise entre 5 nm et 300 nm, par exemple environ 200 nm. Selon un mode de réalisation, la couche semiconductrice 16 peut être formée par un empilement d'au moins deux couches semiconductrices ayant, par exemple, des concentrations de dopants différentes. L'épaisseur de la couche semiconductrice 16 peut être comprise entre 1 $\mu$m et 10 $\mu$m.

Chaque plot conducteur 22 peut correspondre à une couche conductrice, par exemple métallique, ou à un empilement de couches conductrices, par exemple métalliques. Le matériau formant chaque plot conducteur 22 est, par exemple, du siliciure de nickel (NiSi), de l'aluminium (Al), du siliciure d'aluminium (AlSi), du titane (Ti) ou du siliciure de titane (TiSi).

La portion isolante 26 peut être en un matériau diélectrique, par exemple en oxyde de silicium ($SiO_2$), en nitrure de silicium ($Si_xN_y$, où x est environ égal à 3 et y est environ égal à 4, par exemple du $Si_3N_4$), en oxynitrure de silicium (notamment de formule générale $SiO_xN_y$, par exemple du $Si_2ON_2$), en oxyde d'hafnium ($HfO_2$) ou en oxyde d'aluminium ($Al_2O_3$).

Le dispositif optoélectronique 30 peut comprendre plusieurs diodes électroluminescentes distinctes comprenant chacune une zone active 18, le dispositif comprenant, pour chaque diode électroluminescente, un réseau de diffraction 32 en regard de la diode électroluminescente.

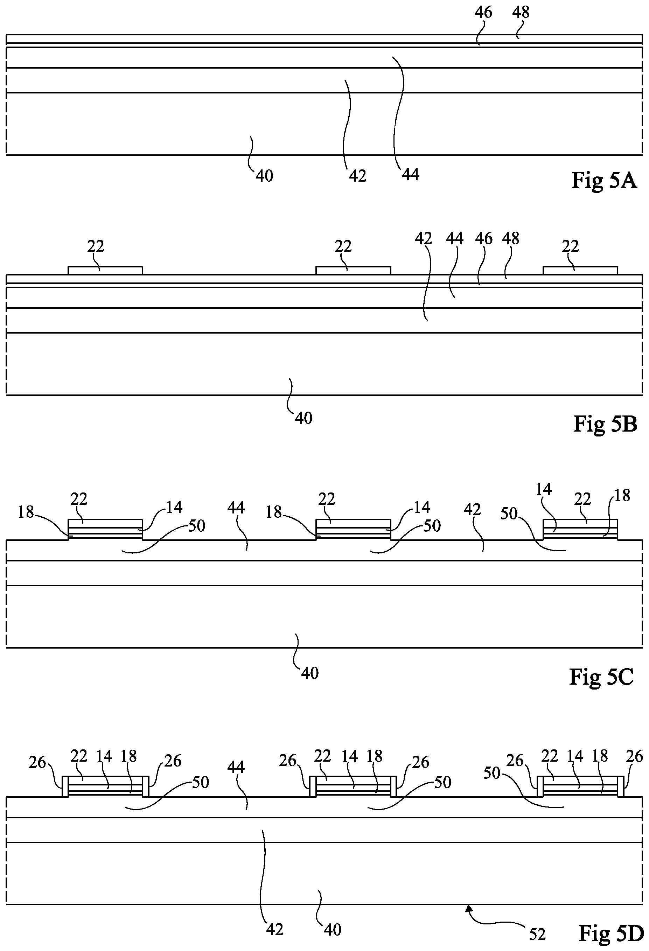

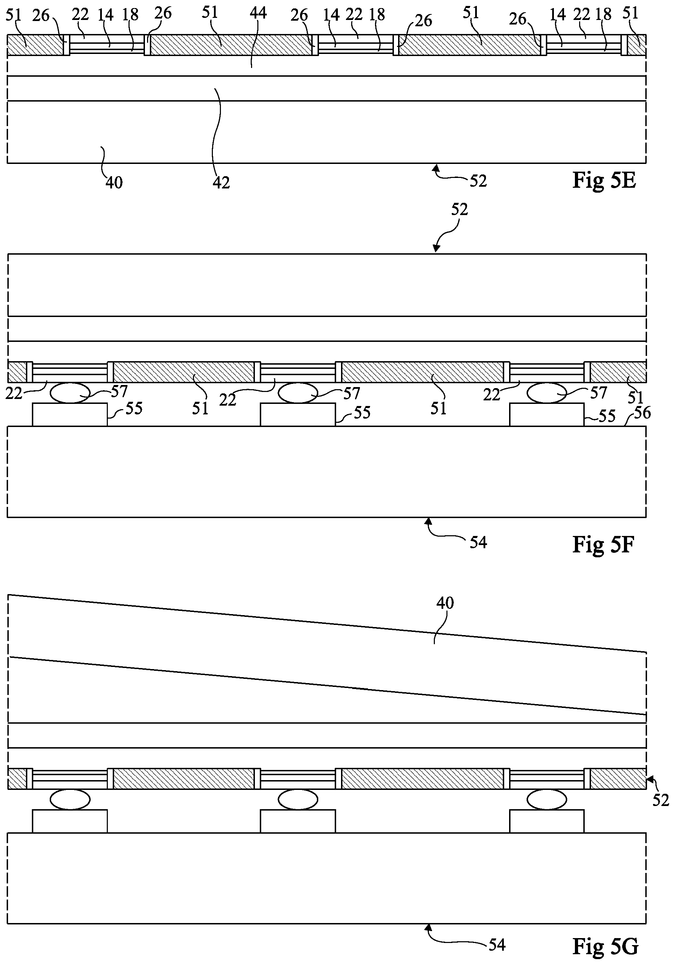

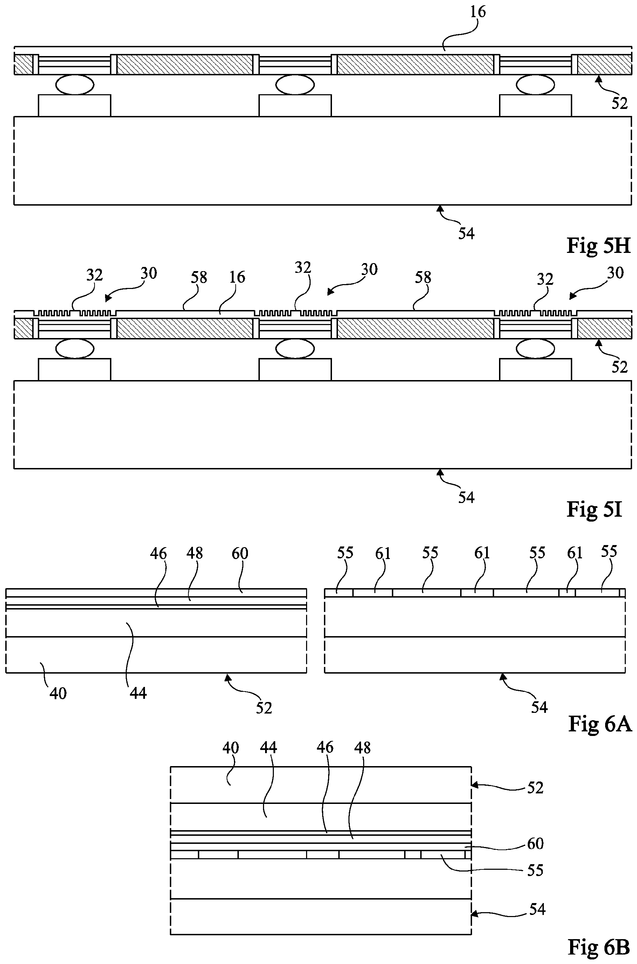

Le réseau de diffraction 32 représenté en figure 4 présente l'avantage que l'efficacité d'extraction ne dépend pas de la polarisation du rayonnement émis par la zone active 18 à la différence du réseau de diffraction 32 représenté en figure 5. Pour un rayonnement donné émis par la zone active 18, la proportion de lumière extraite par le réseau de diffraction 32 représenté en figure 4 est supérieure à la proportion de lumière extraite par le réseau de diffraction 32 représenté en figure 4.

Des simulations ont été réalisées par calcul de différences finies dans le domaine temporel. Pour ces simulations, les couches semiconductrices 14 et 16 étaient en GaN et la zone active 18 comprenait des puits quantiques multiples comprenant une alternance de couches de GaN et de couches de AlGaN. La longueur d'onde $\lambda$ du rayonnement émis par la zone active 18 était de 405 nm. L'épaisseur de la zone active mesurée dans un plan perpendiculaire à la direction Z était de 2 $\mu$m.

Une première simulation a été réalisée avec la structure du dispositif optoélectronique 10 représentée sur la figure 1. Un demi-angle de divergence $\theta_e$ égal à 13,5° a été obtenu. En outre, la réflexion de la lumière émise par la zone active 18 au niveau de la face avant 20 était de 19 %.

Une deuxième simulation a été réalisée avec la structure du dispositif optoélectronique 30 représentée sur les figures 2 et 3. Une troisième simulation a été réalisée avec la structure du dispositif optoélectronique 30 représentée sur les figures 2 et 4. Pour les deuxième et troisième simulations, le rayon R du réseau de diffraction 32 était de 1,2 $\mu$m. La relation (4) donnait la distance F égale à 12,8 $\mu$m.

Pour les deuxième et troisième simulations, on a considéré une pseudopériode P égale à 150 nm, ce qui satisfait la relation (1). On a considéré que le procédé de fabrication des trous 36 et des portions en relief 34 imposait une dimension critique de 50 nm qui correspondait au plus petit motif réalisable. Cela a imposé les facteurs de remplissage extrêmes, à savoir un facteur fmin égal à 1/3 et un facteur fmax égal à 2/3. A partir de la relation (3), on a alors obtenu un indice ñ(0) égal à 2,11 et un indice $\tilde{n}$(R) égal à 1,65. La relation (2) a donné une profondeur h égale à 0,3 $\mu$m. En outre, la relation (2) a donné l'évolution de l'indice local ñ et, à partir de la relation (3), on a obtenu les dimensions de 9 trous (1 trou carré central et 8 trous carrés successifs en s'éloignant radialement du trou carré central dans le cas d'un réseau de diffraction 32 ayant la structure représentée en figure 3 ou une rainure centrale et 8 rainures concentriques dans le cas d'un réseau de diffraction 32 ayant la structure représentée en figure 4). Les valeurs de l'indice local pour les 9 trous sont 2,11/ 2,1028/ 2,0814/ 2,0457/ 1,9956/ 1,9314/ 1,8529/ 1,7602/ 1,6534 et les valeurs de f pour les 9 trous sont 0,333/ 0,3482/ 0,3653/ 0,3934/ 0,4319/ 0,48/ 0,5365/ 0,6003/ 0,6698. Les dimensions radiales des trous 36 sont égales au produit P*f et sont pour les 8 trous 50 nm/ 52,2 nm/ 54,8 nm/ 59 nm/ 64,8 nm/ 72 nm/ 80,5 nm/ 90 nm/ 100 nm. Les deuxième et troisième simulations ont montré que le demi-angle de divergence $\theta_e$ était égal à 8°. On a ainsi obtenu une diminution du demi-angle de divergence $\theta_e$. En outre, pour les deuxième et troisième simulations, la réflexion de la lumière émise par la zone active 18 au niveau de la face avant 20 était 11 %. On a ainsi obtenu une diminution de la réflexion. Ceci entraîne une réduction de l'excitation des modes guidés, de l'ordre d'un facteur 2 et donc une augmentation de l'efficacité d'extraction du dispositif optoélectronique 30 par rapport au dispositif optoélectronique 10 de l'ordre de 50 %.

Les figures 5A à 5I sont des vues en coupe, partielles et schématiques, des structures obtenues à des étapes successives d'un mode de réalisation d'un procédé de fabrication simultanée de plusieurs exemplaires du dispositif optoélectronique 30 représenté sur la figure 2, chaque dispositif optoélectronique 30 correspondant, par exemple, à un pixel d'affichage d'un dispositif d'affichage.

Le procédé comprend les étapes successives suivantes :

(1) Formation, par exemple par épitaxie, sur un substrat 40, d'un empilement de couches semiconductrices comprenant successivement une couche intermédiaire 42, une couche 44 dopée d'un premier type de conductivité, par exemple de type N, une couche active 46 et une couche 48 dopée d'un deuxième type de conductivité, par exemple de type P, opposé au premier type de conductivité (figure 5A). Le substrat 40 peut correspondre à une structure monobloc ou correspondre à une couche recouvrant un support constitué d'un autre matériau. Le substrat 40 peut être un substrat semiconducteur, par exemple un substrat en silicium, en germanium, en carbure de silicium, en un composé III-V, tel que du GaN ou du GaAs, ou un substrat en ZnO. Le substrat 40 peut correspondre à une structure multicouches de type silicium sur isolant, également appelée SOI (acronyme anglais pour Silicon On Insulator). Le substrat 40 peut être en un matériau isolant électriquement, par exemple en saphir.

(2) Dépôt d'une couche métallique sur la couche 48 et gravure de la couche métallique pour délimiter le plot conducteur 22 pour chaque dispositif optoélectronique (figure 5B).

(3) Gravure de la couche 48, de la couche active 46 et d'une partie de l'épaisseur de la couche 44 avec arrêt de la gravure dans la couche 44 pour délimiter, pour chaque dispositif optoélectronique, la couche semiconductrice 14, la zone active 18 et une portion semiconductrice 50 (figure 5C). Les plots 22 jouent le rôle de masque lors de l'opération de gravure.

(4) Dépôt d'une couche isolante électriquement sur l'ensemble de la structure et gravure anisotrope de la couche isolante électriquement pour délimiter la portion isolante 26 pour chaque dispositif optoélectronique (figure 5D).

(5) Dépôt d'une couche métallique sur l'ensemble de la structure et gravure de la couche métallique, par exemple par une planarisation mécanochimique pour délimiter un plot conducteur 51 pour chaque dispositif optoélectronique en contact avec la couche semiconductrice 44 (figure 5E). On obtient ainsi un circuit optoélectronique 52.

(6) Fixation du circuit optoélectronique 52 à un circuit électronique 54 (figure 5F). Le circuit électronique 54 comprend des composants électroniques non représentés. En figure 5F, on a seulement représenté des plots conducteurs 55 sur une face 56 du circuit électronique 54. Les plots conducteurs 55 sont reliés électriquement aux plots conducteurs 22 et/ou 51. Selon l'écartement entre les plots conducteurs 55, la liaison entre le circuit optoélectronique 52 et le circuit électronique 54 peut être réalisée par l'intermédiaire de billes conductrices 57 ou de microtubes.

(7) Retrait du substrat 40, par exemple par un procédé de décollement au laser (en anglais laser lift off) (figure 5G).

(8) Gravure de la totalité de la couche intermédiaire 42 et gravure de la couche semiconductrice 42, seulement sur une partie de l'épaisseur de la couche semiconductrice 42, pour délimiter la couche semiconductrice 16 pour chaque dispositif optoélectronique (figure 5H).

(9) Formation du réseau de diffraction 32 pour chaque dispositif optoélectronique par gravure de motifs dans la couche semiconductrice 16 (figure 5I). On obtient un circuit optoélectronique 52 comprenant plusieurs dispositifs optoélectroniques 30. Une zone 58 de la couche semiconductrice 16 non structurée peut être laissée entre deux dispositifs optoélectroniques 30 adjacents.

Le procédé peut en outre comprendre une étape de dépôt d'une couche transparente recouvrant la couche semiconductrice 16.

Les figures 6A à 6J sont des vues en coupe, partielles et schématiques, des structures obtenues à des étapes successives d'un autre mode de réalisation d'un procédé de fabrication simultanée de plusieurs exemplaires du dispositif optoélectronique 30 représenté sur la figure 2, chaque dispositif optoélectronique 30 correspondant, par exemple, à un pixel d'affichage d'un dispositif d'affichage.

Le procédé comprend les étapes successives suivantes :

(1)' Fabrication de la même structure que celle représentée en figure 5A à la différence que la couche semiconductrice 42 n'est pas représentée et qu'une couche métallique 60 recouvre la couche 48 et fabrication séparée du circuit électronique 54, les plots conducteurs 55 étant représentés séparés par des régions isolantes électriquement 61 (figure 6A).

(2)' Fixation du circuit optoélectronique 52 sur le circuit électronique 54, par exemple par collage (figure 6B). Les plots conducteurs 55 sont reliés électriquement à la couche métallique 60.

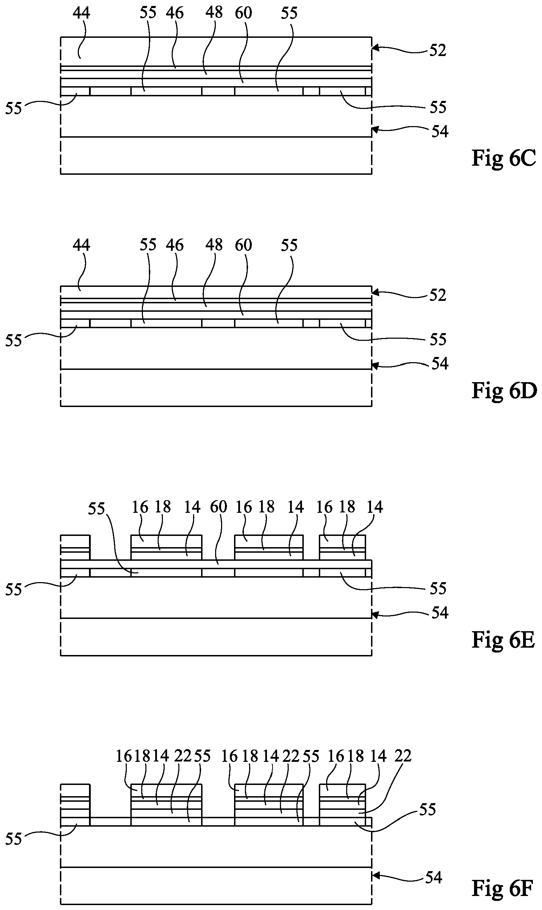

(3)' Retrait du substrat 40 (figure 6C).

(4)' Gravure de la couche semiconductrice 44 sur une partie de son épaisseur (figure 6D).

(5)' Séparation des diodes électroluminescentes, par exemple par la gravure successive des couches semiconductrices 44, 46 et 48 pour délimiter, pour chaque dispositif optoélectronique, la couche semiconductrice 16, la zone active 18 et la couche semiconductrice 14 (figure 6E) et par la gravure de la couche métallique 60 pour délimiter le plot conducteur 22 pour chaque dispositif optoélectronique (figure 6F).

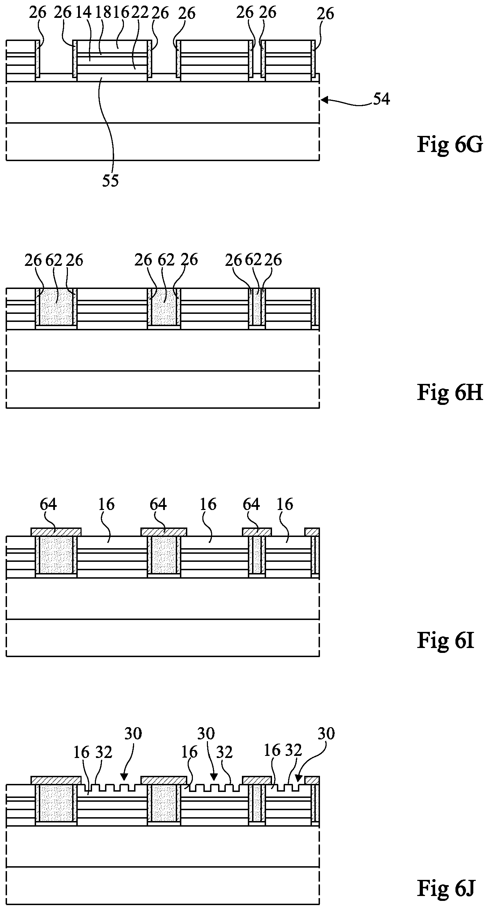

(6)' Dépôt d'une couche isolante électriquement sur l'ensemble de la structure et gravure anisotrope de la couche isolante électriquement pour délimiter les portions isolantes 26 sur les flancs de chaque dispositif optoélectronique (figure 6G).

(7)' Dépôt d'un matériau de remplissage 62 entre les portions isolantes 26 de dispositifs optoélectroniques adjacents (figure 6H). Le matériau de remplissage 62 peut être l'un des matériaux indiqués précédemment pour la portion isolante 26. On effectue ensuite une planarisation mécanochimique pour obtenir des caissons du matériau de remplissage 62.

(8)' Dépôt d'une couche métallique sur la structure obtenue à l'étape précédente pour délimiter des portions conductrices 64 au contact de la couche semiconductrice 16 de chaque dispositif optoélectronique (figure 6I).

(9)' Formation du réseau de diffraction 32 de chaque dispositif optoélectronique 30 par gravure partielle de la couche semiconductrice 16 (figure 6J).

Des modes de réalisation particuliers ont été décrits. Diverses variantes et modifications apparaîtront à l'homme de l'art.

## Revendications

1. Dispositif optoélectronique (30) comprenant une zone active (18) adaptée à fournir un rayonnement électromagnétique et prise en sandwich entre des première et deuxième couches semiconductrices (14, 16), la première couche semiconductrice délimitant une face (20), le dispositif optoélectronique comprenant, en outre, un réseau de diffraction (32) adapté à extraire le rayonnement électromagnétique de la première couche semiconductrice, le réseau de diffraction comprenant des trous (36) s'étendant dans la première couche semiconductrice depuis ladite face, la largeur des trous mesurée dans un plan parallèle à ladite face augmentant de façon continue depuis une partie centrale du réseau de diffraction jusqu'à une partie périphérique du réseau de diffraction, les trous (36) étant agencés en rangées et en colonnes.

2. Dispositif optoélectronique selon la revendication 1, dans lequel les trous (34) sont à section droite circulaire, ellipsoïdale ou polygonale.

3. Dispositif optoélectronique selon la revendication 1 ou 2, dans lequel l'épaisseur de la première couche semiconductrice (16) est comprise entre 1 $\mu$m et 10 $\mu$m.

4. Dispositif optoélectronique selon l'une quelconque des revendications 1 à 3, dans lequel la profondeur des trous (36) est comprise entre 30 nm et 3 $\mu$m.

5. Dispositif optoélectronique selon l'une quelconque des revendications 1 à 4, dans lequel les première et deuxième couches semiconductrices (14, 16) sont au moins en partie formées à partir d'au moins un matériau semiconducteur choisi parmi le groupe comprenant les composés III-V, les composés II-VI ou les semiconducteurs ou composés du groupe IV.

6. Dispositif optoélectronique selon l'une quelconque des revendications 1 à 5, dans lequel la distance entre les points milieu de deux trous (36) adjacents selon une direction radiale du réseau de diffraction (32) est inférieure à la moitié de la longueur d'onde du rayonnement électromagnétique.

7. Procédé de fabrication d'un dispositif optoélectronique (30) comprenant une zone active (18) adaptée à fournir un rayonnement électromagnétique prise en sandwich entre des première et deuxième couches semiconductrices (14, 16), la première couche semiconductrice délimitant une face (20), le procédé comprenant la formation d'un réseau de diffraction (32) adapté à extraire le rayonnement électromagnétique de la première couche semiconductrice, le réseau de diffraction comprenant des trous (36) s'étendant dans la première couche semiconductrice depuis ladite face, la largeur des trous mesurée dans un plan parallèle à ladite face augmentant de façon continue depuis une partie centrale du réseau de diffraction jusqu'à une partie périphérique du réseau de diffraction, les trous (36) étant agencés en rangées et en colonnes.

8. Procédé selon la revendication 7, comprenant une étape de détermination de la profondeur h des trous (36) et de détermination, pour chaque trou, d'un facteur de remplissage f égal au rapport de la largeur, mesurée radialement depuis un centre (O) du réseau de diffraction (32), dudit trou et la distance, mesurée radialement, entre les points milieu de deux trous adjacents selon une direction radiale du réseau de diffraction, le facteur de remplissage f et la hauteur h étant déterminés selon les relations suivantes :

$$\tilde{n}(r) = \tilde{n}(0) - n_i \frac{\left|\sqrt{(F-h)^2 + r^2} - (F-h)\right|}{h}$$

$$\tilde{n}(r)=\sqrt{f(r)n_e{}^2+(1-f(r))n_i{}^2}$$

$$F=\frac{Rcos((n_e/n_i)sin\theta_e)}{(n_e/n_i)sin\theta_e}$$

où r est la distance entre le point milieu du trou (36) et le centre, R est le rayon, mesuré depuis le centre, du cercle circonscrit au réseau de diffraction, $n_i$ est l'indice de réfraction de la première couche semiconductrice (16) à la longueur d'onde du rayonnement électromagnétique, $n_e$ est l'indice de réfraction du milieu au contact de la première couche semiconductrice à la longueur d'onde du rayonnement électromagnétique, $\theta_e$ est le demi-angle de divergence du faisceau émis par le dispositif optoélectronique en l'absence du réseau de diffraction, et $\tilde{n}(r)$ est l'indice de réfraction moyen à la distance r qui permet, en l'absence du réseau de diffraction, d'obtenir la même déviation d'un rayon extrait hors de la première couche semiconductrice que celle obtenue en présence du réseau de diffraction.

**Patentansprüche**

1. Eine optoelektronische Vorrichtung (30) mit einem aktiven Bereich (18), der in der Lage ist, eine elektromagnetische Strahlung zu liefern, und der zwischen einer ersten und einer zweiten Halbleiterschicht (14, 16) angeordnet ist, wobei die erste Halbleiterschicht eine Oberfläche (20) begrenzt, wobei die optoelektronische Vorrichtung ferner ein Beugungsgitter (32) umfasst, das in der Lage ist, die elektromagnetische Strahlung von der ersten Halbleiterschicht zu extrahieren, wobei das Beugungsgitter Löcher (36) aufweist, die sich in der ersten Halbleiterschicht von der Oberfläche aus erstrecken, wobei die Breite der Löcher, gemessen in einer Ebene parallel zu der Oberfläche, von einem zentralen Abschnitt des Beugungsgitters zu einem peripheren Abschnitt des Beugungsgitters kontinuierlich zunimmt, wobei die Löcher (36) in Reihen und in Spalten angeordnet sind.

2. Optoelektronische Vorrichtung nach Anspruch 1, wobei die Löcher (34) einen kreisförmigen, ellipsoiden oder polygonalen Querschnitt aufweisen.

3. Optoelektronische Vorrichtung nach Anspruch 1 oder 2, wobei die Dicke der ersten Halbleiterschicht (16) im Bereich von 1 $\mu$m bis 10 $\mu$m liegt.

4. Optoelektronische Vorrichtung nach einem der Ansprüche 1 bis 3, wobei die Tiefe der Löcher (36) im Bereich von 30 nm bis 3 $\mu$m liegt.

5. Optoelektronische Vorrichtung nach einem der Ansprüche 1 bis 4, wobei die erste und die zweite Halbleiterschicht (14, 16) zumindest teilweise aus mindestens einem Halbleitermaterial gebildet sind, das aus der Gruppe ausgewählt ist, die III-V-Verbindungen, II-VI-Verbindungen oder Halbleiter oder Verbindungen der Gruppe IV aufweist.

6. Optoelektronische Vorrichtung nach einem der Ansprüche 1 bis 5, wobei der Abstand zwischen den Mittelpunkten zweier benachbarter Löcher (36) entlang einer radialen Richtung des Beugungsgitters (32) kürzer als die halbe Wellenlänge der elektromagnetischen Strahlung ist.

7. Ein Verfahren zur Herstellung einer optoelektronischen Vorrichtung (30) mit einem aktiven Bereich (18), der in der Lage ist, eine elektromagnetische Strahlung zu liefern, der zwischen einer ersten und einer zweiten Halbleiterschicht (14, 16) eingeschlossen ist, wobei die erste Halbleiterschicht eine Oberfläche (20) begrenzt, wobei das Verfahren die Bildung eines Beugungsgitters (32) aufweist, das in der Lage ist, die elektromagnetische Strahlung von der ersten Halbleiterschicht zu extrahieren, wobei das Beugungsgitter Löcher (36) aufweist, die sich in der ersten Halbleiterschicht von der Oberfläche aus erstrecken, wobei die Breite der Löcher, gemessen in einer Ebene parallel zu der Oberfläche, von einem zentralen Abschnitt des Beugungsgitters zu einem peripheren Abschnitt des Beugungsgitters kontinuierlich zunimmt, wobei die Löcher (36) in Reihen und in Spalten angeordnet sind.

8. Verfahren nach Anspruch 7, aufweisend einen Schritt zur Bestimmung der Tiefe h der Löcher (36) und zur Bestimmung eines Füllfaktors f für jedes Loch, der gleich dem Verhältnis der radial von einem Zentrum (O) des Beugungsgitters (32) gemessenen Breite des Lochs zu dem radial gemessenen Abstand zwischen den zentralen Punkten zweier benachbarter Löcher entlang einer radialen Richtung des Beugungsgitters ist, wobei der Füllfaktor f und die Höhe h gemäß den folgenden Beziehungen bestimmt werden:

$$\tilde{n}(r)=\tilde{n}(0)-n_i\frac{\left|\sqrt{(F-h)^2+r^2}-(F-h)\right|}{h}$$

$$\tilde{n}(r)=\sqrt{f(r)n_e^2+(1-f(r))n_i^2}$$

$$F=\frac{R\cos((n_e/n_i)\sin\theta_e)}{(n_e/n_i)\sin\theta_e}$$

wobei r der Abstand zwischen dem Mittelpunkt des Lochs (36) und dem Zentrum ist, R der vom Zentrum aus gemessene Radius des Begrenzungskreises des Beugungsgitters ist, $n_i$ der Brechungsindex der ersten Halbleiterschicht (16) bei der Wellenlänge der elektromagnetischen Strahlung ist, $n_e$ der Brechungsindex des Mediums in Kontakt mit der ersten Halbleiterschicht bei der Wellenlänge der elektromagnetischen Strahlung ist, $\theta_e$ der halbe Divergenzwinkel des von der optoelektronischen Vorrichtung in Abwesenheit des Beugungsgitters emittierten Strahls ist und ñ(r) der mittlere Brechungsindex im Abstand r ist, der es in Abwesenheit des Beugungsgitters ermöglicht, die gleiche Abweichung eines aus der ersten Halbleiterschicht herausgezogenen Strahls zu erhalten wie diejenige, die in Anwesenheit des Beugungsgitters erhalten wird.

**Claims**

1. An optoelectronic device (30) comprising an active area (18) capable of supplying an electromagnetic radiation and sandwiched between first and second semiconductor layers (14, 16), the first semiconductor layer delimiting a surface (20), the optoelectronic device further comprising a diffraction grating (32) capable of extracting the electromagnetic radiation from the first semiconductor layer, the diffraction grating comprising holes (36) extending in the first semiconductor layer from said surface, the width of the holes measured in a plane parallel to said surface increasing continuously from a central portion of the diffraction grating to a peripheral portion of the diffraction grating, the holes (36) being arranged in rows and in columns.

2. The optoelectronic device of claim 1, wherein the holes (34) have a circular, ellipsoidal, or polygonal cross-section.

3. The optoelectronic device of claim 1 or 2, wherein the thickness of the first semiconductor layer (16) is in the range from 1 $\mu$m to 10 $\mu$m.

4. The optoelectronic device of any of claims 1 to 3, wherein the depth of the holes (36) is in the range from 30 nm to 3 $\mu$m.

5. The optoelectronic device of any of claims 1 to 4, wherein the first and second semiconductor layers (14, 16) are at least partly formed from at least a semiconductor material selected from the group comprising III-V compounds, II-VI compounds, or group-IV semiconductors or compounds.

6. The optoelectronic device of any of claims 1 to 5, wherein the distance between the central points of two adjacent holes (36) along a radial direction of the diffraction grating (32) is shorter than half the wavelength of the electromagnetic radiation.

7. A method of manufacturing an optoelectronic device (30) comprising an active area (18) capable of supplying an electromagnetic radiation sandwiched between first and second semiconductor layers (14, 16), the first semiconductor layer delimiting a surface (20), the method comprising forming a diffraction grating (32) capable of extracting the electromagnetic radiation from the first semiconductor layer, the diffraction grating comprising holes (36) extending in the first semiconductor layer from said surface, the width of the holes measured in a plane parallel to said surface increasing continuously from a central portion of the diffraction grating to a peripheral portion of the diffraction grating, the holes (36) being arranged in rows and in columns.

8. The method of claim 7, comprising a step of determining depth h of the holes (36) and of determining, for each hole, a filling factor f equal to the ratio of the width, measured radially from a center (O) of the diffraction grating (32), of said hole, to the distance, measured radially, between the central points of two adjacent holes along a radial direction of the diffraction grating, filling factor f and height h being determined according to the following relations:

$$\tilde{n}(r)=\tilde{n}(0)-n_i\frac{\left|\sqrt{(F-h)^2+r^2}-(F-h)\right|}{h}$$

$$\tilde{n}(r)=\sqrt{f(r)n_e^2+(1-f(r))n_i^2}$$

$$F=\frac{R\cos((n_e/n_i)\sin\theta_e)}{(n_e/n_i)\sin\theta_e}$$

where r is the distance between the central point of the hole (36) and the center, R is the radius, measured from the center, of the circumscribed circle of the diffraction grating, $n_i$ is the refraction index of the first semiconductor layer (16) at the wavelength of the electromagnetic radiation, $n_e$ is the refraction index of the medium in contact with the first semiconductor layer at the wavelength of the electromagnetic radiation, $\theta_e$ is the half angle of divergence of the beam emitted by the optoelectronic device in the absence of the diffraction grating, and $\tilde{n}(r)$ is the average refraction index at distance r which enables, in the absence of the diffraction grating, to obtain the same deviation of a ray extracted out of the first semiconductor layer as that obtained in the presence of the diffraction grating.

Fig 1

Fig 2

Fig 3

Fig 4

46  48

40      42  44

**Fig 5A**

22          22      42  44  46  48      22

40

**Fig 5B**

18  22      14          44  18  22      14      42  50      14  22  18
50                          50                          50

40

**Fig 5C**

26  22  14  18  26      44  26  22  14  18  26      50  26  22  14  18  26
50                          50

42      40      52  **Fig 5D**

Fig 5E

Fig 5F

Fig 5G

**16**

**52**

**54**

**Fig 5H**

**32   30   58   16   32   30   58   32   30**

**52**

**54**

**Fig 5I**

**46   48   60      55   61   55   61   55   61   55**

**40   44      52      54**

**Fig 6A**

**40   44   46   48**

**52**

**60**

**55**

**54**

**Fig 6B**

44  55 46 48 60  55

52

55  55

54

**Fig 6C**

44  55 46 48 60  55

52

55  55

54

**Fig 6D**

55  16 18 14 60 16 18 14 16 18 14

55  55

54

**Fig 6E**

16 18 14 22 55  16 18 14 22 55  16 18 14 22

55

55  54  **Fig 6F**

Fig 6G

Fig 6H

Fig 6I

Fig 6J

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120012874 A1
- EP 2752895 A1
- EP 2355182 A2
- EP 1995794 A1
- US 20150117015 A1
- US 20040206969 A1